# EUROPÄISCHE PATENTSCHRIFT

(11) **EP 0 414 138 B1**
(45) Veröffentlichungstag und Bekanntmachung des Hinweises auf die Patenterteilung: **02.11.1994**
(21) Anmeldenummer: 90115741.2
(22) Anmeldetag: 17.08.1990
(51) Int. Cl.: H01L 41/107

(54) **Piezokeramischer Transformator**
Piezoelectric transformer
Transformateur piezoélectrique

(30) Priorität: 19.08.1989 DE 3927406
(43) Veröffentlichungstag der Anmeldung: 27.02.1991
(73) Patentinhaber: Hoechst CeramTec Aktiengesellschaft, 95100 Selb (DE)
(72) Erfinder: Tzchentke, Konrad, D-8561 Eschenbach (DE)
(74) Vertreter: Hoffmann, Peter, Dipl.-Chem.

(56) Entgegenhaltungen:
- DE-B- 1 791 254
- US-A- 4 588 918
- PATENT ABSTRACTS OF JAPAN vol. 13, no. 330 (E-793) 25 Juli 1989 ; & JP-A-193 998

## Beschreibung

Die Erfindung betrifft einen piezokeramischen Transformator zum Transformieren von elektrischen Wechselspannungen.

Piezokeramische Transformatoren sind bekannt. Sie erzeugen unter Ausnutzung des reziproken piezoelektrischen Effekts bei Anlegen einer primären Wechselspannung eine mechanische Resonanzschwingung und wandeln diese durch den direkten piezoelektrischen Effekt in eine sekundäre Wechselspannung um. Da bei der Erzeugung hoher sekundärer Spannungen auch die Resonanzüberhöhung, d. h. die mechanische Schwinggüte ausgenutzt wird, ist es wichtig, mechanische Dämpfungen zu vermeiden oder zumindest klein zu halten. Dies ist auch wichtig, um einen brauchbaren Wirkungsgrad zu erzielen. Da die mechanische Dämpfung im wesentlichen von der Art der Halterung der Piezokeramik abhängt, ist hierauf besonders sorgfältig zu achten. Zur Lösung dieses Problems soll mit der Erfindung ein Piezotransformator mit Halterung zur Verfügung gestellt werden.

Der erfindungsgemäße piezokeramische Transformator ist dadurch gekennzeichnet, daß die Piezokeramik mit den Elektroden in einem Gehäuse aus Silikonkautschuk-Vergußmasse mit einer Shore-Härte ≦ 40 eingegossen ist und das Gehäuse mit. Einrichtungen zum Befestigen des Piezotransformators versehen ist.

Das Gehäuse kann in einer verlorenen Schalung aus Metall, Kunststoff oder dergleichen angeordnet sein, und die Schalung kann Laschen mit Öffnungen zur Aufnahme von Befestigungselementen aufweisen. Als Einrichtung zum Befestigen des Transformators können auch in das Gehäuse oder die verlorene Schalung Gewindebolzen oder Muttern eingespritzt oder eingegossen sein. Auch die Anschlüsse für die Elektroden kommen - als Lötspieße ausgeführt - als Befestigungseinrichtung in Betracht. Mit ihnen kann der Transformator in Schaltplatinen eingesetzt und befestigt werden.

Statt der Spieße können die elektrischen Anschlüsse auch aus eingegossenen Muttern und/oder Gewindebolzen bestehen. Das Gehäuse kann ferner die für den Betrieb eventuell notwendige kapazitive Rückkopplungselektrode, die Kondensatoren und Dioden einer Vervielfacherschaltung zur Erzeugung hoher Gleichspannung sowie eine elektronische Ansteuerschaltung enthalten.

Ausführungsbeispiele der Erfindung sind in den Zeichnungen dargestellt und werden im folgenden näher beschrieben.

Es zeigen:

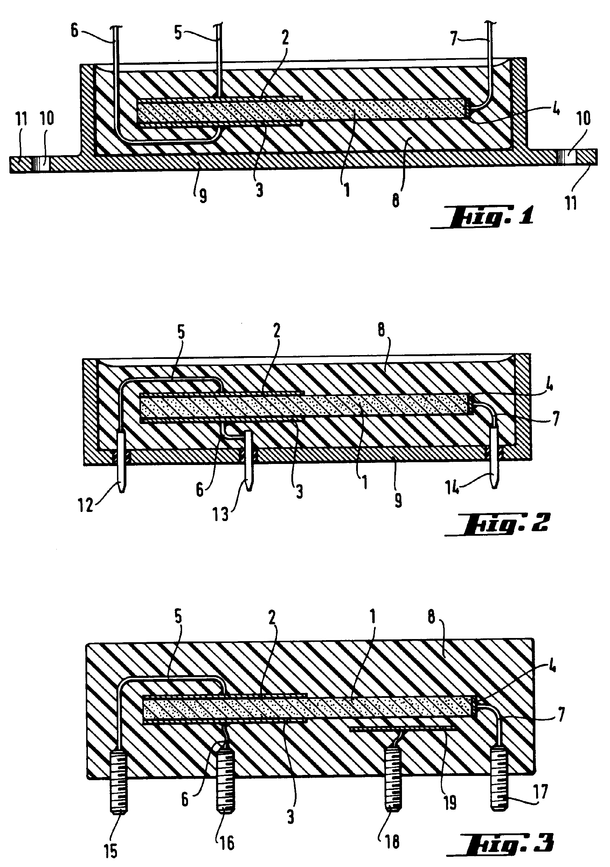

- Figur 1: einen in einem Gehäuse vergossenen Piezotransformator mit Anschlußlitzen und verlorener Schalung geschnitten,
- Figur 2: eine Variante des Piezotransformators gemäß Figur 1 und
- Figur 3: einen in einem Gehäuse vergossenen piezotransformator mit Gewindebolzen als elektrische Anschlüsse und Befestigungselemente.

Bei dem piezokeramischen Transformator ist die piezokeramik (1) mit den dazugehörenden Elektroden (2, 3, 4) und den elektrischen Anschlüssen (5, 6, 7) von einem Gehäuse (8) aus dämpfungsarmer Vergußmasse, z. B. Silikonkautschuk, mit einer Shore-Härte ≦ 40 allseitig umgeben. Das Gehäuse (8) kann in einer verlorenen Schalung (9) aus Metall, Kunststoff oder dergleichen angeordnet Bein. Zur Befestigung des Piezotransformators z. B. auf einer Unterlage, einer Platine oder dergleichen (nicht dargestellt) kann die verlorene Schalung (9) mit Laschen (11) und Öffnungen (10) versehen sein, die zur Aufnahme von Befestigungselementen dienen. Alternativ hierzu kann der Piezotransformator auch mit Lötspießen (12, 13, 14) befestigt werden, die gleichzeitig als Anschlüsse für die Elektroden dienen und im Gehäuse (8) eingegossen und nötigenfalls isoliert durch die verlorene Schalung (9) geführt sind (Figur 2).

Bei der Ausführungsform gemäß Figur 3 sind Gewindebolzen (15, 16, 17, 18) als elektrische Anschlüsse und Befestigung für den Piezotransformator im Gehäuse (8) eingegossen; ebenso eine Rückkopplungselektrode (19).

Der mit der Erfindung erzielte Vorteil besteht insbesondere darin, daß der Anwender den Piezotransformator einbauen kann, wie von den üblichen elektronischen Bausteinen gewohnt, ohne besondere Rücksicht auf die mechanischen Erfordernisse des Piezotransformators nehmen zu müssen. Des weiteren ergeben sich erhebliche Einsparungen an Fertigungsaufwand, wenn weitere Bauelemente wie Gleichrichterschaltung oder Ansteuerelektronik mit eingegossen werden.

## Patentansprüche

1. Piezokeramischer Transformator, dadurch gekennzeichnet, daß die Piezokeramik (1) mit den Elektroden (2, 3, 4) in einem Gehäuse (8) aus Silikonkautschuk-Vergußmasse mit einer Shore-Härte ≦ 40 eingegossen ist, und das Gehäuse (8) mit Einrichtungen (12 bis 18) zum Befestigen des Piezotransformators versehen ist.

2. Piezokeramischer Transformator nach Anspruch 1, dadurch gekennzeichnet, daß das Gehäuse (8) in einer verlorenen Schalung (9) angeordnet ist.

3. Piezotransformator nach Anspruch 2, dadurch gekennzeichnet, daß die Schalung (9) Laschen (11) mit Öffnungen (10) zur Aufnahme von Befestigungselementen aufweist.

## Claims

1. A piezoceramic transformer, wherein the piezoceramic (1) is encapsulated with the electrodes (2, 3, 4) in a housing (8) made of silicone rubber casting compound with a Shore hardness ≦ 40 and the housing (8) is provided with devices (12 to 18) for fastening the piezotransformer.

2. The piezoceramic transformer as claimed in claim 1, wherein the housing (8) is arranged in a lost sheathing (9).

3. The piezotransformer as claimed in claim 2, wherein the sheathing (9) has lugs (11) with openings (10) for accepting fastening elements.

## Revendications

1. Transformateur piézocéramique, caractérisé en ce que la piézocéramique (1) équipée d'électrodes (2,3,4) est enrobée dans un boîtier (8) formé d'une masse de scellement en caoutchouc silicone possédant une dureté Shore ≦ 40, et le boîtier (8) est équipé de dispositifs (12 à 18) servant à fixer le transformateur piézocéramique.

2. Transformateur piézocéramique selon la revendication 1, caractérisé en ce que le boîtier (8) est disposé dans une coque perdue (9).

3. Transformateur piézocéramique selon la revendication 2, caractérisé en ce que la coque (9) comporte des pattes (11) possédant des ouvertures (10) servant à loger des éléments de fixation.
